# EUROPÄISCHE PATENTSCHRIFT

(11) **EP 2 877 866 B1**
(45) Veröffentlichungstag und Bekanntmachung des Hinweises auf die Patenterteilung: **14.09.2016**
(21) Anmeldenummer: 13740259.0
(22) Anmeldetag: 19.07.2013
(51) Int. Cl.: G01R 31/06, H01F 7/18, G01R 27/02, F16K 31/06, B60T 17/22, B60T 8/36

(54) **SCHALTUNGSANORDNUNG ZUR ERFASSUNG EINER ART EINES MAGNETVENTILS**
CIRCUIT ARRANGEMENT FOR DETECTING A TYPE FOR A SOLENOID VALVE
AGENCEMENT DE CIRCUIT SERVANT À DÉTECTER UN TYPE D'ÉLECTROVANNE

(30) Priorität: 26.07.2012 DE 102012014800
(43) Veröffentlichungstag der Anmeldung: 03.06.2015
(73) Patentinhaber: KNORR-BREMSE Systeme für Nutzfahrzeuge GmbH, 80809 München (DE)
(72) Erfinder: SCHOLL, Frank, 74379 Ingersheim (DE); WIEDER, Gerhard, 74354 Besigheim (DE); WINZ, Dieter, 72108 Rottenburg (DE)
(86) Internationale Anmeldenummer: PCT/EP2013/065356
(87) Internationale Veröffentlichungsnummer: WO 2014/016223

(56) Entgegenhaltungen:
- DE-A1-102007 023 189
- DE-A1-102009 016 445
- GB-A- 2 200 505
- US-A1- 2005 071 098

## Beschreibung

Die Erfindung betrifft eine Schaltungsanordnung zur Erfassung einer Art eines Magnetventils, und bezieht sich insbesondere auf eine Schaltungsanordnung zur Erfassung der Art von in einem Fahrzeug verbauten Magnetventilen im Hinblick auf ihre geeignete Auslegung für einen bestehenden Bordnetz-Spannungsbereich. Eine solche Schaltungsanordnung ist aus DE 10 2007 023189 A1 bekannt.

In der Fahrzeugtechnik sind insbesondere bei Nutzfahrzeugen Bordnetze mit zwei unterschiedlichen Bordnetzspannungen üblich. Vorwiegend handelt es sich dabei um Bordnetze mit 12V Nennspannung und Bordnetze mit 24V Nennspannung. Für beide dieser Spannungsbereiche werden normalerweise Magnetventile verwendet, deren Spulen sich in ihrem Widerstand unterscheiden.

Bei Herstellern von Nutzfahrzeugen, die Fahrzeuge mit beiden Bordnetz-Varianten produzieren, kann es vorkommen, dass fälschlicherweise Magnetventile für 12V in Fahrzeugen mit 24V-Bordnetz verbaut werden, oder fälschlicherweise Magnetventile für 24V in Fahrzeugen mit 12V-Bordnetz verbaut werden.

Bisherige Antiblockiersystem- bzw. ABS-Steuergeräte für Nutzfahrzeuge, in deren Umgebung hier insbesondere betrachtete Magnetventile Verwendung finden, erkennen derartige Fehler bisher nicht, so dass es einerseits in einem Fall von Magnetventilen für 24V in einem 12V-Bordnetz dazu kommen kann, dass notwendige Ventilaktivierungen nicht erfolgen, und andererseits in einem Fall von Magnetventilen für 12V in einem 24V-Bordnetz eine Überlastung der Magnetventile durch zu hohe Ströme auftreten kann, die zu deren Ausfall führt.

Die grundlegende Ursache hierfür besteht darin, dass bisherige Bauformen von ABS-Systemen Endstufen von Magnetventilen nur auf Kurzschlüsse zur Masse, Kurzschlüsse zur Bordnetzversorgungsspannung bzw. Batteriespannung, und/oder auf Lastunterbrechungen hin überwachen. Eine Fehlererkennung erfolgt hierbei in der Regel durch Auswertung von Spannungsrückmeldungen. Hochohmige Lasten werden dabei aber erst ab sehr hohen Widerstandswerten erkannt.

Vor diesem Hintergrund liegt der Erfindung als eine Aufgabe zugrunde, die bekannte Schaltungsanordnung dahingehend zu modifizieren, dass eine zuverlässige Bestimmung der Art eines Magnetventils ermöglicht wird.

Erfindungsgemäß wird diese Aufgabe durch die Merkmale des Patentanspruchs 1 gelöst. Vorteilhafte Weiterbildungen der Erfindung sind Gegenstand der beigefügten Unteransprüche.

Der Erfindung liegt der allgemeine Gedanke zugrunde, eine Erkennung eines in einem Fahrzeug, insbesondere einem Nutzfahrzeug, falsch verbauten Magnetventils, d. h. eines Magnetventils, dessen Spannungsbereich nicht zu dem Spannungsbereich des Bordnetzes des Fahrzeugs, in dem es verbaut ist, passt, über den ohmschen Widerstand der jeweils in den Magnetventilen unterschiedlicher Spannungsbereiche vorhandenen Spulen zu erfassen. Während beispielsweise Spulen von für 24V ausgelegten Magnetventilen, beispielsweise 24V-Drucksteuer-Magnetventilen, einen ohmschen Widerstand von typisch etwa 16 Ohm aufweisen, haben Spulen von für beispielsweise 12V ausgelegten Magnetventilen einen ohmschen Widerstand von typisch etwa 5 Ohm. Wird nun ein kleiner Messstrom in jede der vorhandenen Spulen eingeprägt, kann die daraus entstehende Spannung an der Magnetventilspule gemessen und über einen Mikrocontroller in einem entsprechenden Steuergerät zur Bestimmung des Spannungsauslegungsbereichs des Magnetventils ausgewertet werden. Aus der gemessenen Spannung und dem bekannten eingeprägten Strom kann der Widerstand der Magnetventilspule berechnet und bestimmt werden.

Gemäß diesem allgemeinen Gedanken der Erfindung ist die vorgeschlagene Schaltungsanordnung dahin gehend vorteilhaft, dass die Messschaltung kostengünstig einfach gehalten werden kann, bei entsprechender Auslegung aber dennoch eine Messgenauigkeit derart bereitstellt, dass über einen spezifizierten Spannungsbereich, Temperaturbereich und Toleranzbereich wenigstens zwei Spulentypen sicher unterscheidbar sind. Ein weiterer Vorteil besteht darin, dass die Auslegung der Schaltungsanordnung derart möglich ist, dass ohne Beschränkung auf eine tatsächliche Höhe einer Bordnetz-Nennspannung bereits geringe eingeprägte Ströme für die Spulentypbestimmung ausreichen, so dass die Erfassung des Spulentyps möglich ist, ohne das zugehörige Magnetventil elektrisch und/oder mechanisch zu aktivieren. Die Spulentypbestimmung kann daher systemtransparent und als solche auf übrige Funktionen beispielsweise des zugrundeliegenden ABS-Systems auswirkungslos, in anderen Worten ohne Beeinträchtigung oder Störung derselben, erfolgen.

Die Aufgabe wird somit gelöst durch eine Schaltungsanordnung zur Erfassung einer Art eines Magnetventils in Fahrzeugen, gekennzeichnet durch zumindest ein zur Erfassung seiner Art in die Schaltungsanordnung eingebundenes Magnetventil, das zumindest eine Spulenwicklung mit einem ohmschen Widerstand einer für eine vorbestimmte Bordnetz-Versorgungsspannung typischen Größenordnung aufweist; eine Konstantstromquelle, die dazu angeordnet ist, einen vorbestimmten Messstrom in die zumindest eine Spulenwicklung des zumindest einen Magnetventils einzuprägen; eine Stromspiegelschaltung, die dazu angeordnet ist, aus einer durch den eingeprägten Messstrom an der zumindest einen Spulenwicklung des zumindest einen Magnetventils entstehenden ersten Spannung eine zweite Spannung an einem Erfassungsabschnitt der Schaltungsanordnung zu erzeugen; wobei die an dem Erfassungsabschnitt erzeugte zweite Spannung an dem Erfassungsabschnitt direkt an einen Mikrocontroller in einer Steuereinrichtung zur Bestimmung der Art des Magnetventils ausgeleitet wird.

Hierdurch kann mittels einem einfach und kostengünstigen Schaltungsaufbau, der auch in ein bereits vorhandenes Steuergerät oder Magnetventilmodul integrierbar, oder als zusätzliches Modul, ausgestaltet sein kann, eine zuverlässige Erkennung einer Betriebsspannung eines Magnetventils durchgeführt werden, wobei die Erkennung nur einmalig während oder nach einer Initialisierung der übrigen Steuerelektronik durchgeführt zu werden braucht, und die Erkennung dabei noch ohne funktionelle Auswirkung auf ein jeweils gemessenes Magnetventil bleibt und damit zu keiner weiteren Betätigung oder Aktivierung des Magnetventils oder anderer Komponenten in dessen Wirkungsumfeld führt. Ferner erlaubt eine geeignete Auslegung des Schaltungsaufbaus auch eine Widerstandsmessung gegen Massepotenzial, ist über diese Widerstandsmessung auch eine defekte Spulenwicklung ermittelbar, beispielsweise wenn der erwartete typische Widerstandswert nicht mehr bestimmt werden kann, und kann durch eine solche Widerstandsmessung auch die Temperatur bzw. Temperaturänderung der Spulenwindung erfasst werden.

Vorzugsweise ist die erfasste Art eines Magnetventils eine Bordnetz-Versorgungsspannung, für welche das Magnetventil ausgelegt ist, wobei die Bordnetz-Versorgungsspannung Nennspannungen von 12V und/oder 24V und/oder mehr als 24V beinhaltet, und ist das Magnetventil ein Drucksteuer-Magnetventil zur Verwendung in Bremsanlagen und/oder Antischlupfregelanlagen eines Nutzfahrzeugs.

Hierdurch kann in sicherheitsrelevanten Teilen eines Nutzfahrzeugs auf rasche und zweckmäßige Weise durch Unterscheidung zweier möglicher Varianten und Ermittlung, ob eine Fehlverbauung, beispielsweise ab Herstellerwerk oder auch nach einem Werkstattaufenthalt, vorliegt, die zu einem Nichtansprechen eines Magnetventils und/oder einem Ausfall eines Magnetventils führen kann, auf einen korrekten Systemzustand geschlossen werden.

Liegt die Größenordnung des ohmschen Widerstands der Spulenwicklung des Magnetventils für eine Nennspannung von 12 V typisch in einem einstelligen Widerstandsbereich und für eine von dieser unterscheidbar höhere Nennspannung typisch in einem zweistelligen bis dreistelligen Widerstandsbereich, ist eine sichere und dennoch aktivierungslose Erfassung im Rahmen der Größenordnungen anderer Systemsignale möglich.

Bevorzugt beinhaltet die Konstantstromquelle einen Transistor, der an Emitter, Basis und Kollektor mit jeweils einem ohmschen Widerstand beschaltet ist und an dessen Basisanschluss ein Spannungssignal anliegt, das im Messzustand der Schaltungsanordnung 5V beträgt.

Weiter bevorzugt ist der von der Konstantstromquelle in die zumindest eine Spulenwicklung des zumindest einen Magnetventils eingeprägte Messstrom derart ausgelegt, dass eine Magnetventilarterfassung sicher möglich ist, sein Fließen aber noch nicht zu einer funktionellen Aktivierung eines jeweils gemessenen Magnetventils führt, und beträgt der Messstrom näherungsweise 9 mA.

Dadurch wird es möglich, bei einfachem Aufbau und Nutzung von im Gesamtsystem vorhandener Spannungspotenziale einen geeigneten Messstrom zu erzeugen und einzuprägen.

Bevorzugt beinhaltet die Stromspiegelschaltung einen Operationsverstärker, dessen Eingangsspannungsbereich bis hin zu seiner Versorgungsspannung reichend ausgelegt ist, einen Transistor und einen zweiten ohmschen Widerstand, der den Erfassungsabschnitt bildet, und überträgt die Stromspiegelschaltung die erste Spannung an einen mit dem Transistor zur Bordnetz-Versorgungsspannung hin verbundenen ersten Widerstand.

Diese Anordnung erlaubt es, auf einfache Art und Weise die durch den eingeprägten Messstrom an der Spule eines gemessenen Magnetventils erzeugte Spannung an einen Schaltungsabschnitt zu übertragen, an dem diese von einem Mikrocontroller übernommen und ausgewertet werden kann. Besondere Vorteile ergeben sich daraus, dass eine an externen Stellen, beispielsweise an in Radmodulen verbauten Magnetventilen, erzeugte Spannung, geeignet in eine interne Erfassungsspannung umsetzbar ist, und diese durch Auslegung des Stromspiegels zusätzlich an bestehende Anforderungen anpassbar ist.

Vorteilhaft ist in Reihe zu dem zumindest einen Magnetventil zumindest ein erster Highside-Schalter zur Aktivierung der Spule des zumindest einen Magnetventils vorgesehen, ist ein für das zumindest eine Magnetventil gemeinsamer zweiter Schalter parallel zu der Konstantstromquelle gegen Massepotenzial vorgesehen, der in einem normalen Betriebszustand geschlossen ist, und ist an der Konstantstromquelle ein dritter Schalter zur schaltbaren Einprägung des Konstantstroms vorgesehen, wobei in einem Messbetriebszustand der dritte Schalter geschlossen ist, der zweite Schalter geöffnet ist, und der zumindest eine erste Schalter geschlossen ist.

Diese Anordnung ermöglicht es dann, wenn mehrere Magnetventile vorhanden sind, durch definiertes Setzen der Schaltzustände der einzelnen Schalter eine separate und/oder sequenzielle Messung einzelner Magnetventile durchzuführen und auszuwerten, indem beispielsweise zunächst der zweite und der dritte Schalter in einen für die Messung bestimmten Zustand versetzt werden und danach die bei mehreren Magnetventilen insgesamt mehrfach, an jedem einzelnen Magnetventil aber jeweils nur einmal vorhandenen ersten Schalter nacheinander Ein/Aus- bzw. durchgeschaltet werden, und somit der eingeprägte Messstrom jeweils nur durch ein bzw. die gewünschte(n) Spulen der zu messenden Magnetventile fließt.

Bevorzugt sind eine Empfindlichkeit und/oder ein Erfassungsbereich der Schaltungsanordnung einstellbar, wobei dabei der ohmsche Widerstand der Magnetspulen über das Übertragungsverhältnis U1/U2 von erster Spannung zu zweiter Spannung und den eingeprägten Messstrom berechenbar ist.

Ist die Empfindlichkeit und/oder der Erfassungsbereich der Schaltungsanordnung einstellbar bzw. umschaltbar, wird es möglich, die Genauigkeit der Messung zu beeinflussen und gegebenenfalls anzupassen, und/oder bedarfsweise einen größeren Widerstandsunterschied zwischen den Widerstandswerten einzelner Magnetventilspulen zu messen. Zum einen wird dadurch die Schaltungsanordnung universeller einsetzbar, und zum anderen wird es möglich, einzelne Magnetventile durch etwa Ventile eines anderen, z.B. neueren, Typs mit anderen Spulenwiderstandswerten zu ersetzen, ohne Änderungen an der übrigen Schaltungsanordnung vornehmen zu müssen. Da zudem die durch den eingeprägten Messstrom erzeugte erste Spannung bzw. deren nach der Spiegelung umgesetzter Wert erfassbar und der eingeprägte Messstrom selbst bekannt sind, erlaubt dies eine Spulenwiderstandserfassung ohne nennenswerte Belastung des Systems hinsichtlich Zeitdauer und Rechenaufwand.

Bevorzugt bildet die Schaltungsanordnung Teil eines Antiblockier-Bremssystems und/oder Teil eines Antischlupfregelsystems für Nutzfahrzeuge.

In derart sicherheitsrelevanten Abschnitten von Fahrzeugen ist die Integration einer erfindungsgemäß zusätzlichen Erkennung des Vorhandenseins eines Magnetventils korrekter Auslegung bezüglich der Bordnetz-Versorgungsspannung besonders vorteilhaft, weil beispielsweise bereits bei einer Systemaktivierung während etwa einer Endkontrolle im Herstellerwerk oder nach einer erfolgten Wartung oder Reparatur durch geeignete Signalisierung vermeidbar wird, dass ein Fahrzeug mit betriebsungeeigneten Teilen zumindest zunächst wieder am Verkehr teilnimmt. In anderen Worten wird die Gefahr, dass ein Fehler durch a) eine Nichtreaktion eines Magnetventils wegen mangelnder Ansteuerbarkeit und/oder b) ein teilweise Systemausfall wegen Zerstörung eines Magnetventils nach Betrieb außerhalb seiner Spezifikation und/oder Überlastung in den Verantwortungsbereich eines Fahrers des Nutzfahrzeugs gelangt, wirksam verringert.

Im Einzelnen ist insgesamt die erfindungsgemäße Schaltungsanordnung dem Grunde nach dadurch gekennzeichnet, dass eine Batterie als Bordnetz-Versorgungsspannung vorgesehen ist, ein erster Widerstand und zumindest ein erster Schalter an jeweils einem ersten Anschluss mit einem hohen Potenzial der Bordnetz-Versorgungsspannung verbunden sind, ein Transistor an einem Emitteranschluss mit dem ersten Widerstand verbunden ist, ein Operationsverstärker an einem Ausgang desselben mit einem Basisanschluss des Transistors verbunden ist, ein invertierender Eingang des Operationsverstärkers mit dem ersten Widerstand und dem Emitteranschluss des Transistors verbunden ist, ein nichtinvertierender Eingang des Operationsverstärkers mit einem ersten Anschluss eines zweiten Schalters, einem ersten Anschluss eines dritten Schalters, und einem zweiten Anschluss des zumindest einen Magnetventils verbunden ist, ein erster Anschluss des zumindest einen Magnetventils mit einem zweiten Anschluss des zumindest einen ersten Schalters verbunden ist, ein Kollektoranschluss des Transistors mit einem ersten Anschluss eines zweiten Widerstands verbunden ist, ein zweiter Anschluss des dritten Schalters mit einem ersten Anschluss der Konstantstromquelle verbunden ist, und jeweils ein zweiter Anschluss des zweiten Widerstands, ein zweiter Anschluss der Konstantstromquelle und ein zweiter Anschluss des zweiten Schalters mit einem niedrigen Potenzial der Bordnetz-Versorgungsspannung verbunden sind, wobei die Ausleitung der zweiten Spannung als Messspannung an den Mikrocontroller zwischen dem ersten Anschluss des zweiten Widerstands und dem Kollektoranschluss des Transistors erfolgt.

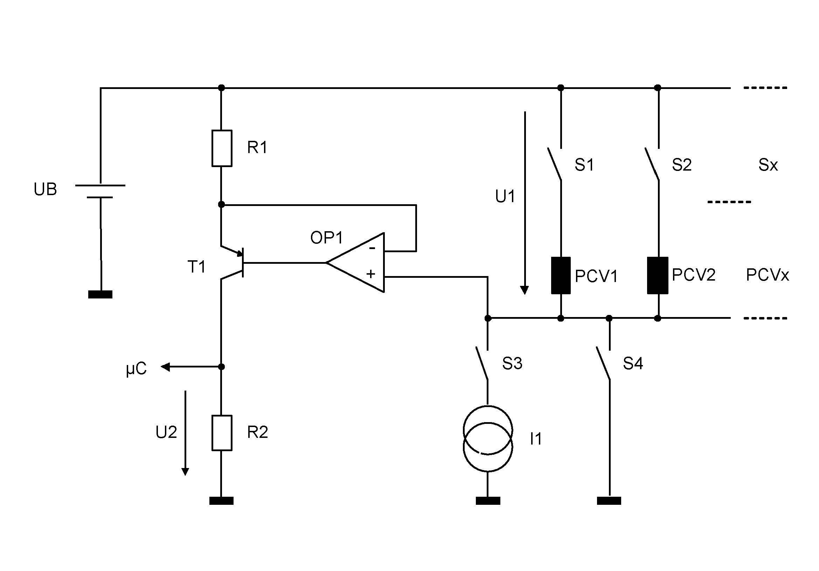

Die Erfindung wird nachstehend anhand eines bevorzugten Ausführungsbeispiels der Schaltungsanordnung unter Bezugnahme auf die Zeichnung näher beschrieben. Es zeigt die einzige Figur:
Eine vereinfachte Darstellung einer Schaltungsanordnung zur Erfassung der Art eines Magnetventils gemäß einem Ausführungsbeispiel.

Gemäß der Figur ist eine Bordnetz-Spannungsversorgung für ein Fahrzeug, etwa ein Nutzfahrzeug, vorgesehen. Die Bordnetz-Spannungsversorgung kann zum Beispiel eine Batterie sein, die eine Versorgungs- oder Batteriespannung UB von 12V oder 24V bereitstellt. Die Bordnetz-Spannungsversorgung ist jedoch nicht auf diese Spannungen beschränkt. Vielmehr ist die Schaltungsanordnung bei entsprechender Auslegung für beliebige Bordnetz-Spannungsversorgungen bzw. beliebige Bordnetz-Nennspannungen geeignet, beispielsweise auch für solche mit Versorgungs- oder Batteriespannungen von mehr als 24V, wie etwa 42V oder dergleichen. Mit dem Pluspotenzial der Bordnetz-Spannungsversorgung sind im gezeigten Ausführungsbeispiel ein erster Anschluss eines ersten ohmschen Widerstands R1, ein erster Anschluss eines ersten Schalters S1 und ein erster Anschluss eines zweiten Schalters S2 verbunden. Der zweite Schalter S2 ist bevorzugt in Form eines einfachen oder doppelten Feldeffekttransistors ausgeführt.

Ein zweiter Anschluss des ersten ohmschen Widerstands R1 ist mit einem Emitteranschluss eines Transistors T1 verbunden. Der Transistor T1 ist wie dargestellt beispielsweise ein PNP-Transistor, jedoch nicht darauf beschränkt. Der Kollektoranschluss des Transistors T1 ist mit einem ersten Anschluss eines zweiten ohmschen Widerstands R2 verbunden. Der Basisanschluss des Transistors T1 ist mit einem Ausgang eines Operationsverstärkers OP1 verbunden, welchem an seinem invertierenden Eingangsanschluss das Potenzial an dem zweiten Anschluss des ersten ohmschen Widerstands R1 zugeführt wird. Der Operationsverstärker OP1 ist hierbei bevorzugt ein solcher, dessen Eingangsspannungsbereich bis hin zu seiner Versorgungsspannung reicht.

Der nichtinvertierende Anschluss des Operationsverstärkers OP1 ist mit einem ersten Anschluss eines dritten Schalters S3 verbunden. An einem zweiten Anschluss des dritten Schalters S3 ist ein erster Anschluss einer Stromquelle I1 verbunden, die an einem zweiten Anschluss wiederum auf Massepotenzial liegt.

Der erste Anschluss des dritten Schalters S3 liegt auf demselben Potenzial wie ein zweiter Anschluss einer ersten Magnetventilspule PCV1, ein zweiter Anschluss einer zweiten Magnetventilspule PCV2 und ein erster Anschluss eines vierten Schalters S4. Ein zweiter Anschluss des vierten Schalters S4 liegt auf Massepotenzial, und ein erster Anschluss der ersten Magnetventilspule PCV1 und ein erster Anschluss der zweiten Magnetventilspule PCV2 sind jeweils mit einem zweiten Anschluss des ersten Schalters S1 und einem zweiten Anschluss des zweiten Schalters S2 verbunden.

Obwohl in der Figur zwei Reihenschaltungen aus Schaltern S1, S2 und Magnetventilspulen PCV1, PCV2 gezeigt sind, sind diese lediglich stellvertretend für beliebig viele Magnetventilspulen PCV1, PCV2, ..., PCVx dargestellt, die in entsprechender Verschaltung mit Schaltern S1, S2, ..., Sx möglich sind, wie in der Figur durch die weiterführend durchbrochenen Linien angedeutet ist.

In einer praktischen Ausgestaltung und/oder Modifikation der in der Figur vereinfacht dargestellten Schaltungsanordnung ist der vierte Schalter S4 ein für alle Magnetventilspulen gemeinsamer Schalter gegen Massepotenzial, der in einem normalen Betriebszustand geschlossen ist. Außerdem sind der erste Schalter S1 und der zweite Schalter S2 als so genannte Highside-Schalter und bevorzugt als Highside-Transistorschalter oder Highside-Feldeffekttransistoren ausgeführt, die als solche mit dem positiven Versorgungspotenzial verbunden sind und nicht auf Massepotenzial bezogen, sondern gegen das positive Versorgungspotenzial schalten. Der erste Schalter S1 und der zweite Schalter S2 sind dazu angeordnet, die Magnetventilspulen PCV1 und PCV2 während eines Regelungseingriffs zu aktivieren.

Da wie vorstehend beschrieben Highside-Schalter zur Aktivierung der einzelnen Magnetventilspulen PCV1, PCV2, ..., PCVx verwendet werden, muss die zur Bestimmung des ohmschen Widerstands der Magnetventilspulen PCV1, PCV2, ..., PCVx zu erfassende Spannung gegen die Bordnetz-Versorgungsspannung UB gemessen und in geeigneter Weise an den auf Massepotenzial liegenden (nicht gezeigten) Mikrocontroller übertragen werden. Es wird angemerkt, dass die Messung sinngemäß selbstverständlich auch gegen das Massepotenzial durchgeführt werden kann.

Die Stromquelle I1 bildet eine Konstantstromquelle und ist dazu angeordnet, über ein Schließen des dritten Schalters S3 (und des ersten Schalters S1 bzw. des zweiten Schalters S2) den Messstrom in die Magnetventilspulen PCV1, PCV2, ..., PCVx einzuprägen. Hierzu wird gemäß dem Ausführungsbeispiel eine Stromquellenschaltung zur Einprägung eines konstanten Stroms oder Konstantstroms als Messstrom derart genutzt (in anderen Worten erfolgt die Messung durch Einprägen eines Konstantstroms), dass die gemessene Spannung U1 an der jeweiligen Magnetventilspule PCV1, PCV2, ..., PCVx von der Höhe der Batterie- bzw. Bordnetz-Versorgungsspannung unabhängig ist. Im Einzelnen kann die Stromquelle I1 einen an Basis, Emitter und Kollektor jeweils mit einem geeigneten ohmschen Widerstand beschalteten Transistor, beispielsweise einem NPN-Transistor oder FET, beinhalten, mit einer am Basisanschluss des Transistors anliegenden Spannung von im Messzustand 5V.

Die Stromquelle I1 ist bevorzugt derart ausgelegt, dass sie in dem hier betrachteten Ausführungsbeispiel zur Unterscheidung von Magnetventilspulen für Bordnetz-Nennspannungen von 12V bzw. 24V und typischen Spulenwiderständen von 5 Ohm, d. h. einem Wert in einem einstelligen Widerstandsbereich, bzw. etwa 16 Ohm, d. h. einem Wert in einem zweistelligen Widerstandsbereich, bei diesen beiden Bordnetz-Versorgungsspannungen einen konstanten Messstrom von etwa 9 mA erzeugt, der zur sicheren Unterscheidung der Art der gemessenen Magnetventilspule (ihrer Nennspannung) betragsmäßig ausreichend groß ist, aber noch nicht zu einer Aktivierung der Magnetventilspule führt.

Es versteht sich, dass für andere Bordnetz-Nennspannungen oder für Magnetventile anderer Bauart oder anderen Verwendungszwecks, etwa Drucksteuer-Magnetventilen für Antischlupf-Regelsysteme bzw. ASR-Systeme, welche derzeit beispielsweise einen Spulenwiderstand in der Größenordnung zwischen 8 Ohm, d. h. einen Wert in einem einstelligen Widerstandsbereich, und 128 Ohm, d. h. einen Wert in einem dreistelligen Widerstandsbereich, aufweisen können, die Schaltungsanordnung zur Erkennung und Unterscheidung auch solcher Magnetventile insgesamt und damit auch für entsprechend andere zu messende Widerstandswerte und/oder konstante Messströme auslegbar ist.

Der Operationsverstärker OP1, der Transistor T1 und der zweite Widerstand R2 bilden eine Stromspiegelschaltung, die die an den parallel zueinander liegenden Reihenschaltungen aus Schaltern S1, S2, ..., Sx und Magnetventilspulen PCV1, PCV2, ..., PCVx messbare Spannung U1 zunächst auf den ersten Widerstand (R1) und sodann als Spannung U2 auf den zweiten ohmschen Widerstand R2 spiegeln bzw. übertragen. Wie in der Figur schematisch durch einen mit µC bezeichneten Pfeil dargestellt, erfolgt die Ausleitung der Spannung U2 direkt an den Mikrocontroller zwischen dem ersten Anschluss des zweiten Widerstands R2 und dem Kollektoranschluss des Transistors T1.

Die Messung der ohmschen Widerstände der Magnetventilspulen PCV1, PCV2, ..., PCVx muss vorteilhaft nur einmal, beispielsweise während oder nach einem Einschaltvorgang des Steuergeräts erfolgen.

Um eine solche Widerstandsmessung der Magnetventilspulen PCV1, PCV2, ..., PCVx für eine Erfassung deren (Spannungs-) Typs bzw. Art durchzuführen, werden der zweite Schalter S2 geöffnet, der dritte Schalter S3 geschlossen und nacheinander alle jeweils den einzelnen Magnetventilspulen PCV1, PCV2, ..., PCVx zugeordneten Schalter S1, S2, ..., Sx geschlossen. Über das innerhalb der Schaltungsanordnung bekannte Spannungsübertragungsverhältnis U1/U2 und den ebenfalls bekannten eingeprägten Messstrom aus der Stromquelle I1 kann der ohmsche Widerstand der einzelnen Magnetventilspulen PCV1, PCV2, ..., PCVx bestimmt bzw. berechnet werden, sofern die an den Schaltern S1, S2, ..., Sx abfallende Sättigungsspannung hinreichend klein oder aber bekannt ist.

Außerdem kann vorgesehen sein, die Schaltungsanordnung hinsichtlich Empfindlichkeit und/oder Erfassungsbereich derart einstellbar oder umschaltbar auszugestalten, dass eine genauere Messung und/oder größere bzw. erweiterte Widerstandsbereiche messbar sind. Eine solche Einstellbarkeit oder Umschaltbarkeit kann beispielsweise dadurch erzielt werden, dass der von der Konstantstromquelle I1 erzeugte Konstantstrom in seinem absoluten Betrag steuerbar variabel ausgelegt wird, zumindest ein Element der Stromspiegelschaltung steuerbar variabel ausgelegt wird, und/oder der zweite Widerstand R2, beispielsweise nach Art einer Widerstandsmatrix aus mehreren parallelen und über jeweilige Schalter in ihren Zuleitungen einzeln schaltbaren Widerständen, variabel steuerbar ausgelegt wird. In Abhängigkeit von einem Angriffspunkt der Einstellbarkeit bzw. Umschaltbarkeit kann dabei eine Änderung beispielsweise über den Mikrocontroller bzw. durch Software gesteuert, oder durch festverdrahtete Einstellpunkte entsprechend veranlasst werden. Allgemein besteht eine Beschränkung auf eine bestimmte konstruktive Ausführung der Einstellbarkeit oder Umschaltbarkeit nicht, solange durch eine konkrete Ausführungsform das innerhalb der Schaltungsanordnung bekannte Spannungsübertragungsverhältnis U1/U2 und/oder der ebenfalls bekannte eingeprägte Messstrom aus der Stromquelle I1 zur Bestimmung oder Berechnung des ohmschen Widerstands der einzelnen Magnetventilspulen PCV1, PCV2, ..., PCVx zur Verbesserung der Messgenauigkeit oder Erweiterung des Messbereichs geeignet beeinflusst werden.

Es wird angemerkt, dass über die hierin beschriebene Messung des ohmschen Widerstands der Magnetventilspulen PCV1, PCV2, ... PCVx (d. h. die Widerstandsmessung) zusätzlich auch ein Defekt einer Spulenwicklung, wie beispielsweise ein Windungsschluss, erfassbar ist. Rückschlüsse hierauf können beispielsweise in dem auswertenden Mikrocontroller dann gezogen werden, wenn etwa ein typisch zu erwartender Widerstandswert nicht mehr vorliegt bzw. bestimmbar ist. Außerdem sind durch eine solche Widerstandsmessung prinzipiell auch eine Temperatur und/oder eine Temperaturänderung einer Wicklung einer Magnetventilspule erfassbar.

Es versteht sich, dass das vorstehend beschriebenen Ausführungsbeispiel nicht auf die beispielhaft angegebenen Elemente und konkreten Verschaltungsformen beschränkt ist, sondern dass einzelne oder auch mehrere Elemente durch gleichwirkende Elemente, Verschaltungen mehrerer Elemente, Ausführungsformen, insbesondere auch bei Polaritätsumkehr und/oder Verwendung anderer Leitungstypen und/oder Ausführungen jeweils verwendeter elektronischer Schalterarten, darstellbar sind. Ebenso versteht sich, dass die hierin beschriebene Widerstandserfassung von Magnetventilspulen nicht auf Magnetventile in einem ABS-System oder einem ASR-System beschränkt ist, sondern bei einer Vielzahl anderer Anordnungen und Systeme, auch solchen nicht nur in Fahrzeugen oder Nutzfahrzeugen, durchführbar ist, die den Grundanforderungen für eine solche Widerstandsmessung genügen und eine direkte Messung von (eingeprägten) Ventilströmen in Magnetventilspulen erlauben.

Derartige Modifikationen, die zu der vorstehenden detaillierten Beschreibung eines bevorzugten Ausführungsbeispiels vergleichbar oder äquivalent sind, und ebenso weitere Schaltungselemente, die zur geeigneten funktionellen Anpassung, Abstimmung und/oder Auslegung weitere Beschaltung bilden können, für das Wirkprinzip der erfindungsgemäßen Schaltungsanordnung jedoch nicht wesentlich sind, sowie deren konkrete Auswahl, erschließen sich dem Fachmann ohne weiteres und sind daher nicht als Abweichen vom Gegenstand der Erfindung und Verlassen deren Schutzumfangs gemäß den beigefügten Patentansprüchen zu werten.

## Patentansprüche

1. Schaltungsanordnung zur Erfassung einer Art eines Magnetventils in Fahrzeugen, aufweisend
zumindest ein zur Erfassung seiner Art in die Schaltungsanordnung eingebundenes Magnetventil (PCV1, ... PCVx), das zumindest eine Spulenwicklung mit einem ohmschen Widerstand einer für eine vorbestimmte Bordnetz-Versorgungsspannung (UB) typischen Größenordnung aufweist,
eine Konstantstromquelle (I1), die dazu angeordnet ist, einen vorbestimmten Messstrom in die zumindest eine Spulenwicklung des zumindest einen Magnetventils (PCV1, ..., PCVx) einzuprägen, **gekennzeichnet durch**
eine Stromspiegelschaltung (OP1, T1, R2), die dazu angeordnet ist, aus einer **durch** den eingeprägten Messstrom an der zumindest einen Spulenwicklung des zumindest einen Magnetventils (PCV1, ..., PCVx) entstehenden ersten Spannung (U1) eine zweite Spannung (U2) an einem Erfassungsabschnitt (R2) der Schaltungsanordnung zu erzeugen, wobei
die an dem Erfassungsabschnitt (R2) erzeugte zweite Spannung (U2) an dem Erfassungsabschnitt (R2) direkt an einen Mikrocontroller in einer Steuereinrichtung zur Bestimmung der Art des Magnetventils ausgeleitet wird.

2. Schaltungsanordnung nach Anspruch 1, **dadurch gekennzeichnet, dass** die erfasste Art eines Magnetventils eine Bordnetz-Versorgungsspannung ist, für welche das Magnetventil ausgelegt ist, wobei die Bordnetz-Versorgungsspannung Nennspannungen von 12V und/oder 24V und/oder mehr als 24V beinhaltet, und dass das Magnetventil ein Drucksteuer-Magnetventil zur Verwendung in Bremsanlagen und/oder Antischlupfregelanlagen eines Nutzfahrzeugs ist.

3. Schaltungsanordnung nach Anspruch 2, **dadurch gekennzeichnet, dass** die Größenordnung des ohmschen Widerstands der Spulenwicklung des Magnetventils für eine Nennspannung von 12 V typisch in einem einstelligen Widerstandswertbereich liegt und für eine höhere Nennspannung typisch in einem zweistelligen bis dreistelligen Widerstandswertbereich liegt.

4. Schaltungsanordnung nach einem der vorangehenden Ansprüche, **dadurch gekennzeichnet, dass** die Konstantstromquelle (I1) einen Transistor beinhaltet, der an Emitter, Basis und Kollektor mit jeweils einem ohmschen Widerstand beschaltet ist und an dessen Basisanschluss ein Spannungssignal anliegt, das im Messzustand der Schaltungsanordnung 5V beträgt.

5. Schaltungsanordnung nach einem der vorangehenden Ansprüche, **dadurch gekennzeichnet, dass** der von der Konstantstromquelle (I1) in die zumindest eine Spulenwicklung des zumindest einen Magnetventils (PCV1, ..., PCVx) eingeprägte Messstrom derart ausgelegt ist, dass eine Magnetventilarterfassung sicher möglich ist, sein Fließen aber noch nicht zu einer funktionellen Aktivierung eines jeweils gemessenen Magnetventils führt, und der Messstrom näherungsweise 9 mA beträgt.

6. Schaltungsanordnung nach einem der vorangehenden Ansprüche, **dadurch gekennzeichnet, dass** die Stromspiegelschaltung (OP1, T1, R2) einen Operationsverstärker (OP1), dessen Eingangsspannungsbereich bis hin zu seiner Versorgungsspannung reichend ausgelegt ist, einen Transistor (T1) und einen zweiten ohmschen Widerstand (R2), der den Erfassungsabschnitt bildet, beinhaltet, und die Stromspiegelschaltung (OP1, T1, R2) die erste Spannung (U1) an einen mit dem Transistor (T1) zur Bordnetz-Versorgungsspannung (UB) hin verbundenen ersten Widerstand (R1) überträgt.

7. Schaltungsanordnung nach einem der vorangehenden Ansprüche, **dadurch gekennzeichnet, dass** in Reihe zu dem zumindest einen Magnetventil (PCV1, ..., PCVx) zumindest ein erster Highside-Schalter (S1, ..., Sx) zur Aktivierung der Spule des zumindest einen Magnetventils (PCV1, ..., PCVx) vorgesehen ist, ein für das zumindest eine Magnetventil (PCV1, ..., PCVx) gemeinsamer zweiter Schalter (S2) parallel zu der Konstantstromquelle (I1) gegen Massepotenzial vorgesehen ist, der in einem normalen Betriebszustand geschlossen ist, und an der Konstantstromquelle (I1) ein dritter Schalter (S3) zur schaltbaren Einprägung des Konstantstroms vorgesehen ist, wobei in einem Messbetriebszustand der dritte Schalter (S3) geschlossen ist, der zweite Schalter (S2) geöffnet ist, und der zumindest eine erste Schalter (S1, ..., Sx) geschlossen ist.

8. Schaltungsanordnung nach einem der vorangehenden Ansprüche, **dadurch gekennzeichnet, dass** eine Empfindlichkeit und/oder ein Erfassungsbereich der Schaltungsanordnung einstellbar sind, wobei der ohmsche Widerstand der Magnetspulen über das Übertragungsverhältnis U1/U2 von erster Spannung (U1) zu zweiter Spannung (U2) und den eingeprägten Messstrom berechenbar ist.

9. Schaltungsanordnung nach einem der vorangehenden Ansprüche, **dadurch gekennzeichnet, dass** die Schaltungsanordnung Teil eines Antiblockier-Bremssystems und/oder Teil eines Antischlupfregelsystems für Nutzfahrzeuge bildet.

10. Schaltungsanordnung nach Anspruch 1, **dadurch gekennzeichnet, dass** eine Batterie als Bordnetz-Versorgungsspannung (UB) vorgesehen ist, ein erster Widerstand (R1) und zumindest ein erster Schalter (S1, ... Sx) an jeweils einem ersten Anschluss mit einem hohen Potenzial der Bordnetz-Versorgungsspannung (UB) verbunden sind, ein Transistor (T1) an einem Emitteranschluss mit dem ersten Widerstand (R1) verbunden ist, ein Operationsverstärker (OP1) an einem Ausgang desselben mit einem Basisanschluss des Transistors (T1) verbunden ist, ein invertierender Eingang des Operationsverstärkers (OP1) mit dem ersten Widerstand (R1) und dem Emitteranschluss des Transistors (T1) verbunden ist, ein nichtinvertierender Eingang des Operationsverstärkers (OP1) mit einem ersten Anschluss eines zweiten Schalters (S2), einem ersten Anschluss eines dritten Schalters (S3), und einem zweiten Anschluss des zumindest einen Magnetventils (PCV1, ..., PCVx) verbunden ist, ein erster Anschluss des zumindest einen Magnetventils (PCV1, ..., PCVx) mit einem zweiten Anschluss des zumindest einen ersten Schalters (S1, ..., Sx) verbunden ist, ein Kollektoranschluss des Transistors (T1) mit einem ersten Anschluss eines zweiten Widerstands (R2) verbunden ist, ein zweiter Anschluss des dritten Schalters (S3) mit einem ersten Anschluss der Konstantstromquelle (I1) verbunden ist, und jeweils ein zweiter Anschluss des zweiten Widerstands (R2), ein zweiter Anschluss der Konstantstromquelle (I1) und ein zweiter Anschluss des zweiten Schalters (S2) mit einem niedrigen Potenzial der Bordnetz-Versorgungsspannung (UB2) verbunden sind, wobei die Ausleitung der zweiten Spannung (U2) als Messspannung an den Mikrocontroller zwischen dem ersten Anschluss des zweiten Widerstands (R2) und dem Kollektoranschluss des Transistors (T1) erfolgt.

## Claims

1. Circuit arrangement for detecting a type of solenoid valve in vehicles, having at least one solenoid valve (PCV1, ..., PCVx) which is incorporated into the circuit arrangement for the purpose of detecting the type of said solenoid valve and has at least one coil winding having a resistance which is of the typical order of magnitude for a predetermined vehicle electrical distribution system supply voltage (UB);
a constant current source (I1), which is arranged so as to impress a predetermined measurement current into the at least one coil winding of the at least one solenoid valve (PCV1,..., PCVx);
a current mirror circuit (OP1, T1, R2), which is arranged so as to generate a second voltage (U2) on a detection section (R2) of the circuit arrangement from a first voltage (U1) produced as a result of the impressed measurement current on the at least one coil winding of the at least one solenoid valve (PCV1, ..., PCVx); wherein
the second voltage (U2) produced on the detection section (R2) is passed out, on the detection section (R2), directly to a microcontroller in a control device for determining the type of solenoid valve.

2. Circuit arrangement according to Claim 1, **characterized in that** the detected type of solenoid valve is a vehicle electrical distribution system supply voltage for which the solenoid valve is designed, wherein the vehicle electrical distribution system supply voltage includes rated voltages of 12 V and/or 24 V and/or more than 24 V, and **in that** the solenoid valve is a pressure control solenoid valve for use in braking systems and/or traction control systems of a utility vehicle.

3. Circuit arrangement according to Claim 2, **characterized in that** the order of magnitude of the resistance of the coil winding of the solenoid valve for a rated voltage of 12 V is typically within a single-digit resistance value range, and for a higher rated voltage, is typically within a two-digit to three-digit resistance value range.

4. Circuit arrangement according to one of the preceding claims, **characterized in that** the constant current source (I1) comprises a transistor, which is connected to a respective resistance at the emitter, base and collector, with a voltage signal which is 5 V in the measurement state of the circuit arrangement being applied to the base connection of said transistor.

5. Circuit arrangement according to one of the preceding claims, **characterized in that** the measurement current impressed by the constant current source (I1) into the at least one coil winding of the at least one solenoid valve (PCV1, ..., PCVx) is designed such that solenoid valve type detection is reliably possible, but the flow of said measurement current does not yet result in functional activation of a respectively measured solenoid valve, and the measurement current is approximately 9 mA.

6. Circuit arrangement according to one of the preceding claims, **characterized in that** the current mirror circuit (OP1, T1, R2) comprises an operational amplifier (OP1), whose input voltage range up to its supply voltage is sufficient, a transistor (T1) and a second resistance (R2), which forms the detection section, and the current mirror circuit (OP1, T1, R2) transmits the first voltage (U1) to a first resistance (R1), which is connected to the transistor (T1) towards the vehicle electrical distribution system supply voltage (UB).

7. Circuit arrangement according to one of the preceding claims, **characterized in that** at least one first high-side switch (S1, ..., Sx) for activating the coil of the at least one solenoid valve (PCV1, ..., PCVx) is provided in series with the at least one solenoid valve (PCV1, ..., PCVx), a second switch (S2), which is common for the at least one solenoid valve (PCV1, ..., PCVx), is provided in parallel with the constant current source (I1) to ground potential, wherein said second switch is closed in the normal operating state, and a third switch (S3) for switchably impressing the constant current is provided at the constant current source (I1), wherein, in a measurement operation state, the third switch (S3) is closed, the second switch (S2) is open, and the at least one first switch (S1, ..., Sx) is closed.

8. Circuit arrangement according to one of the preceding claims, **characterized in that** a sensitivity and/or a detection range of the circuit arrangement is/are adjustable, wherein the resistance of the solenoid coils can be calculated via the transformation ratio U1/U2 of the first voltage (U1) to the second voltage (U2) and the impressed measurement current.

9. Circuit arrangement according to one of the preceding claims, **characterized in that** the circuit arrangement forms part of an anti-lock braking system and/or part of a traction control system for utility vehicles.

10. Circuit arrangement according to Claim 1, **characterized in that** a battery is provided as vehicle electrical distribution system supply voltage (UB), a first resistance (R1) and at least one first switch (S1, ..., Sx) are connected at in each case one first connection to a high potential of the vehicle electrical distribution system supply voltage (UB), a transistor (T1) is connected at an emitter connection to the first resistance (R1), an operational amplifier (OP1) is connected at an output thereof to a base connection of the transistor (T1), an inverting input of the operational amplifier (OP1) is connected to the first resistance (R1) and to the emitter connection of the transistor (T1), a noninverting input of the operational amplifier (OP1) is connected to a first connection of a second switch (S2), a first connection of a third switch (S3), and a second connection of the at least one solenoid valve (PCV1, ..., PCVx), a first connection of the at least one solenoid valve (PCV1, ..., PCVx) is connected to a second connection of the at least one first switch (S1, ..., Sx), a collector connection of the transistor (T1) is connected to a first connection of a second resistance (R2), a second connection of the third switch (S3) is connected to a first connection of the constant current source (I1), and in each case a second connection of the second resistance (R2), a second connection of the constant current source (I1), and a second connection of the second switch (S2) are connected to a low potential of the vehicle electrical distribution system supply voltage (UB2), wherein the second voltage (U2) as measurement voltage is passed out to the microcontroller between the first connection of the second resistance (R2) and the collector connection of the transistor (T1).

## Revendications

1. Montage de circuit à détecter un type d'électrovanne dans des véhicules, comprenant
- au moins une électrovanne (PCV1, ..., PCVx) intégrée dans le montage de circuit pour la détection de son type, qui comprend au moins un enroulement de bobine à une résistance ohmique d'une tension d'alimentation de réseau de bord prédéterminée (UB) de l'ordre typique,
- une source de courant constant (K1) disposée aux fins d'appliquer un courant de mesure prédéterminé dans ledit au moins un enroulement de bobine de ladite au moins une électrovanne (PCV1, ..., PCVx),
**caractérisé par**
- un circuit miroir de courant (OP1, T1, R2) disposé aux fins d'engendrer, à partir d'une première tension (U1) créée par ledit courant de mesure appliqué audit au moins un enroulement de bobine de ladite au moins une électrovanne (PCV1, ..., PCVx), une deuxième tension (U2) à une partie de détection (R2) du montage de circuit, dans lequel
- ladite deuxième tension (U2) engendrée à ladite partie de détection (R2) est sortie à ladite partie de détection (R2) directement à un microcontrôleur dans un moyen de commande pour la détermination du type de ladite électrovanne.

2. Montage de circuit selon la revendication 1, **caractérisé en ce que** le type détecté d'une électrovanne est une tension d'alimentation de réseau de bord, pour lequel ladite électrovanne est conçue, à ladite tension d'alimentation de réseau de bord comprenant des tensions nominales de 12 V et/ou 24 V et/ou plus de 24 V, et **en ce que** ladite électrovanne est une électrovanne de commande de pression pour l'utilisation dans des systèmes de freinage et/ou des systèmes d'antipatinage d'un véhicule utilitaire.

3. Montage de circuit selon la revendication 2, **caractérisé en ce que** l'ordre de la résistance ohmique dudit enroulement de bobine de ladite électrovanne se trouve typiquement dans une gamme de valeurs de résistance à un chiffre pour une tension nominale de 12 V, et se trouve typiquement dans une gamme de valeurs de résistance à deux à trois chiffres pour une plus haute tension nominale.

4. Montage de circuit selon une quelconque des revendications précédentes, **caractérisé en ce que** ladite source de courant constant (I1) comprend un transistor auquel une résistance ohmique respective est appliquée à son émetteur, à sa base et son collecteur, et auquel un signal de tension est appliqué à sa borne de base, qui a 5 V en état de mesure du montage de circuit.

5. Montage de circuit selon une quelconque des revendications précédentes, **caractérisé en ce que** le courant de mesure appliqué par ladite source de courant constant (I1) audit au moins un enroulement de bobine de ladite au moins une électrovanne (PCV1, ..., PCVx) est conçu de façon, qu'une sûre détection du type de l'électrovanne devienne possible, qu'un écoulement du courant ne résulte pas déjà en une activation fonctionnelle d'une électrovanne mesurée respective, et que le courant de mesure soit 9 mA par approximation

6. Montage de circuit selon une quelconque des revendications précédentes, **caractérisé en ce que** ledit circuit miroir de courant (OP1, T1, R2) comprend un amplificateur opérationnel (OP1), dont la gamme de tension d'entrée est conçue jusqu'à sa tension d'alimentation, un transistor (T1) et une deuxième résistance ohmique (R2), qui constitue la partie de détection, et **en ce que** ledit circuit miroir de courant (OP1, T1, R2) transmet ladite première tension (U1) à une première résistance (R1) branchée audit transistor (T1) vers ladite tension d'alimentation de réseau de bord (UB).

7. Montage de circuit selon une quelconque des revendications précédentes, **caractérisé en ce qu'**au moins un premier commutateur côté haut (S1, ..., Sx) est disposé en série à ladite au moins une électrovanne (PCV1, ..., PCVx) pour l'activation de ladite bobine de ladite au moins une électrovanne (PCV1, .., PCVx), **en ce qu'**un deuxième commutateur (S2) commun pour ladite au moins une électrovanne (PCV1, ..., PCVx) est disposé en parallèle à ladite source de courant constant (I1) mise à potentiel de terre, qui, en une état de fonctionnement normal, est fermé, et **en ce qu'**un troisième commutateur (S3) est disposé à ladite source de courant constant (I1) pour l'application commutable du courant constant, audit troisième commutateur (S3) étant fermé en un état fonctionnel de mesure, audit deuxième commutateur (S2) étant ouvert et audit au moins premier commutateur (S1, ..., Sx) étant fermé.

8. Montage de circuit selon une quelconque des revendications précédentes, **caractérisé en ce qu'**une sensibilité et/ou une gamme de détection du montage de circuit sont ajustable, à ladite résistance ohmique desdites bobines magnétiques étant calculable via le rapport de transmission U1/U2 de ladite première tension (U1) vers ladite deuxième tension (U23) et ledit courant de mesure appliqué.

9. Montage de circuit selon une quelconque des revendications précédentes, **caractérisé en ce que** le montage de circuit constitue un composant d'un système de freinage antipatinage et/ou une partie d'un système antipatinage pour des véhicules utilitaires.

10. Montage de circuit selon la revendication 1, **caractérisé en ce qu'**une batterie est disposée en tant que source de tension d'alimentation de réseau de bord (UB), qu'une première résistance (R1) et au moins un premier commutateur (S1, ..., Xs) sont branchés à une première borne respective à un haut potentiel de ladite tension d'alimentation de réseau de bord, qu'un transistor (T1) est branché par sa borne d'émetteur à ladite première résistance (R1), qu'un amplificateur opérationnel (OP1) est branché par une de ses sorties à une borne de base dudit transistor (T1), qu'une entrée à inversion dudit amplificateur opérationnel (OP1) est branchée à ladite première résistance (R1) et à la borne d'émetteur dudit transistor (T1), qu'une entrée non-inverseuse dudit amplificateur opérationnel (OP1) est branchée à une première borne d'un deuxième commutateur (S2), à une première borne d'un troisième commutateur (S3) et à une deuxième borne de ladite au moins une électrovanne (PCV1, ..., PCVx), qu'une première borne de ladite au moins une électrovanne (PCV1, ..., PCVx) est branché à une deuxième borne dudit au moins un premier commutateur (S1, .., Sx), qu'un borne de collecteur dudit transistor (T1) est branché à une première borne d'une deuxième résistance (R2), qu'une deuxième borne de ladite troisième borne (S3) est branchée à une première borne de ladite source de courant constant (I1), et **en ce qu'**une deuxième borne respective de ladite deuxième résistance (R2), une deuxième borne de ladite source de courant constant (I1) et une deuxième borne dudit deuxième commutateur (S2) sont branchées à un bas potentiel de ladite tension d'alimentation de réseau de bord (IB2), à la sortie de ladite deuxième tension (U2) se fait en tant que tension de mesure audit microcontrôleur entre ladite première borne de ladite deuxième résistance (R2) et la borne de collecteur dudit transistor (T1).
